# EUROPÄISCHE PATENTANMELDUNG

(11) **EP 2 838 331 A1**
(43) Veröffentlichungstag der Anmeldung: **18.02.2015**
(21) Anmeldenummer: 14162561.6
(22) Anmeldetag: 31.03.2014
(51) Int. Cl.: H05K 9/00

(54) **Textiles Flächengebilde**

(30) Priorität: 13.08.2013 DE 202013103659 U
(71) Anmelder: REHAU AG + Co, 95111 Rehau (DE)
(72) Erfinder: Kania, Guido, 91080 Marloffstein (DE); Winterling, Ralf, 91074 Herzogenaurach (DE)

(57) **Zusammenfassung**

Die vorliegende Erfindung betrifft ein textiles Flächengebilde zur Anordnung um wenigstens ein Höchstspannungskabel, um das sich um das stromdurchflossene Höchstspannungskabel bildende Magnetfeld wenigstens teilweise abzuschirmen, mit wenigstens einer Schicht, das sich dadurch auszeichnet, dass die Schicht ein weichmagnetisches Material enthält.

## Beschreibung

Die Erfindung betrifft ein textiles Flächengebilde zur Anordnung um wenigstens ein Höchstspannungskabel. Weiterhin betrifft die Erfindung eine Stromleitungsanordnung, welche wenigstens ein Höchstspannungskabel und ein textiles Flächengebilde umfasst.

Im Zuge des Ausbaus der erneuerbaren Energien, insbesondere der sogenannten Offshore- und Onshore-Windkraft, der Photovoltaik und der Biogaserzeugung, bei denen elektrische Energie generiert wird, ist es notwendig, diese elektrische Energie Verbrauchern zuzuleiten.

Neben den bekannten Hochspannungs-Freileitungen wird dabei vermehrt auch auf Anordnungen von Höchstspannungskabeln unter der Erde gesetzt. Bei derartigen Höchstspannungskabeln liegen Spannungen von mehr als 100 kV, meist 380 kV vor. Entsprechende Vorkehrungen sind zu treffen, um von diesen Kabeln ausgehende Effekte physikalischer Natur zu beherrschen. Durch den Stromfluss im Kabel wird einerseits Wärme erzeugt, die abzuführen ist, andererseits bildet sich um stromdurchflossene Kabel ein Magnetfeld. Die Effekte sind groß und sind bedingt durch die hohe Stromstärke, die durch die Kabel fließt.

Ein wesentlicher Punkt ist dabei, das sich um das stromdurchflossene Höchstspannungskabel bildende Magnetfeld möglichst effektiv abzuschirmen. Dies gelingt bereits teilweise dadurch, dass solche Höchstspannungskabel entweder paarweise oder bei einer sogenannten Drehstromanordnung als drei etwa parallel verlaufende Höchstspannungskabel angeordnet sind. Durch diese Anordnung wird das sich bildende Magnetfeld durch gegenseitige Kompensation - hervorgerufen durch die Ströme in den Höchstspannungskabelnbereits sehr deutlich verringert. Dennoch kann es notwendig sein, weitere Abschirmmaßnahmen zu ergreifen, um das Restmagnetfeld unter die nach den einschlägigen Verordnungen genehmigten Grenzwerte bzw. projektspezifischen Anforderungen zu bringen.

Hier setzt die Erfindung ein, die es sich zur Aufgabe gemacht hat, eine einfache und effektive, insbesondere verbesserte Abschirmung des sich um stromdurchflossene Höchstspannungskabel bildende Magnetfeldes zu erreichen. Eine weitere Aufgabe der vorliegenden Erfindung ist es, eine Stromleitungsanordnung anzugeben, die wenigstens ein Höchstspannungskabel umfasst und bei der eine einfache und möglichst effektive Abschirmung des sich bildenden Magnetfeldes vorliegt.

Die Aufgabe wird gelöst mit einem textilen Flächengebilde gemäß Anspruch 1 zur Anordnung um wenigstens ein Höchstspannungskabel, um das sich um das stromdurchflossene Höchstspannungskabel bildende Magnetfeld wenigstens teilweise abzuschirmen.
Dazu weist das textile Flächengebildete wenigstens eine Schicht auf.
Es zeichnet sich dadurch aus, dass die Schicht ein weichmagnetisches Material enthält.

Mit einem derartigen erfindungsgemäßen textilen Flächengebilde gelingt es in einfacher und effektiver Weise, das sich um das stromdurchflossene Höchstspannungskabel bildende Magnetfeld wenigstens teilweise abzuschirmen. Die Abschirmung erfolgt durch das in der Schicht des textilen Flächengebildes vorgesehene weichmagnetische Material.

Im vorliegenden Erfindungszusammenhang wird unter Abschirmung, beispielsweise unter der Bezeichnung "wenigstens teilweise abzuschirmen" und ebenso anderer vergleichbarer Bezeichnungen eine Abschirmung, also Verminderung des Magnetfeldes verstanden.
Dies kann anhand von sogenannten "Abschirmfaktoren" quantifiziert werden.
Bei einem Abschirmfaktor von 2 ist das ursprünglich vorhandene Magnetfeld durch die Abschirmung auf die Hälfte reduziert, entsprechend bei einem Abschirmfaktor von 10 auf ein Zehntel.
Im vorliegenden Erfindungszusammenhang wird zugrunde gelegt, dass sich die Werte auf die magnetische Feldstärke um ein stromdurchflossenes Höchstspannungskabel jeweils ohne und mit der Anordnung des textilen Flächengebildes beziehen.
Durch die Erfindung ist es möglich, Abschirmfaktoren von 2 bis 100 zu realisieren, also das ursprünglich vorhandene Magnetfeld auf die Hälfte bis auf ein Hundertstel zu reduzieren.

Es hat sich in einer bevorzugten Ausführungsform der vorliegenden Erfindung herausgestellt, dass ein solches textiles Flächengebilde dann sehr vorteilhaft ist, wenn das weichmagnetische Material eine magnetische Permeabilitätszahl µr von > 500 aufweist.

Ein weichmagnetisches Material mit einer magnetischen Permeabilitätszahl µr von > 500 ist ganz besonders gut dafür geeignet, sich um stromdurchflossene Höchstspannungskabel bildende Magnetfelder möglichst effektiv abzuschirmen.

Im vorliegenden Erfindungszusammenhang hat sich als äußerst günstig herausgestellt, wenn das weichmagnetische Material Eisen oder eine Eisen-Silizium-Legierung oder eine Eisen-Nickel-Legierung oder ein µ-Metall oder eine Mischung der vorgenannten ist.

Mit einem weichmagnetischen Material aus Eisen oder einer Eisen-Silizium-Legierung oder einer Eisen-Nickel-Legierung oder einem µ-Metall oder einer Mischung der vorgenannten gelingt es in ganz besonders günstiger Weise, das sich um stromdurchflossene Höchstspannungskabel bildende Magnetfeld wenigstens teilweise abzuschirmen.

In einer günstigen Fortbildung der vorliegenden Erfindung kann vorgesehen sein, dass das weichmagnetische Material als Filament oder als Draht oder als Band oder als Folie oder als Partikel ausgebildet ist. Die weichmagnetischen Materialien gemäß obiger Aufzählung lassen sich in einfacher Weise zu Filamenten oder Drähten oder Bänder oder Folien oder Partikel ausbilden. Hierzu sind vergleichsweise einfache Verfahrensschritte bekannt. Weichmagnetische Materialien als Filament oder als Draht oder als Band oder als Folie oder als Partikel lassen sich für die Abschirmung von Magnetfeldern sehr effektiv nutzen.

In einer weiteren Fortbildung der Erfindung kann in vorteilhafterweise Weise vorgesehen sein, dass das Filament oder der Draht als Geflecht oder als Gestrick oder als Zopf oder als eine parallele Draht- oder Filamentschar oder als Wirrgelege angeordnet ist.

Durch das Anordnen des Filaments oder des Drahts als Geflecht oder als Gestrick oder als Zopf oder als eine parallele Draht- oder Filamentschar oder als Wirrgelege lässt sich das weichmagnetische Material in eine sehr stabile Anordnung überführen, die für weitere Prozessschritte bei der Herstellung des textilen Flächengebildes sehr gut geeignet ist.

Damit gelingt es, je nach der erwünschten Abschirmung des Magnetfeldes durch Wahl des weichmagnetischen Materials, dessen Form als Draht oder als Band oder als Folie oder als Partikel, dessen Anteil im textilen Flächengebilde sowie der Anordnung des weichmagnetischen Materials, das erfindungsgemäße textile Flächengebilde so zu dimensionieren, dass dieses eine maximale Wirksamkeit im Hinblick auf die Abschirmung magnetischer Felder, die von Höchstspannungskabeln ausgehen, aufweisen.

Besondere Bedeutung kommt dabei der Wahl des Materials und der Dicke des in Form gebrachten Materials zu, da dadurch einerseits die Abschirmung bedingt wird, andererseits kommt es durch Wirbelströme im weichmagnetischen Material zu Verlusten elektrischer Leistung. Dies kann durch die vorliegende Erfindung in geeigneter Weise "ausbalanciert" werden. Dabei hat sich ergeben, dass Drähte aus weichmagnetischen Material besser als Bänder oder Folien geeignet sind, das Magnetfeld abzuschirmen, ohne dass der Verlust an elektrischer Übertragungsleistung zu groß wird.

In sehr günstiger Weise kann bei dem textilen Flächengebilde der vorliegenden Erfindung vorgesehen sein, dass die Schicht Glasfasern oder Kohlenstofffasern oder Gesteinsfasern oder Keramikfasern oder Metallfasern oder Aramidfasern oder Polyesterfasern oder Polyamidfasern oder andere Polymerfasern oder eine Kombination der vorstehend genannten Fasern enthält.

Ein textiles Flächengebilde mit einer Schicht aus den vorgenannten Fasern ist in einfacher Weise zugänglich, kostengünstig, stabil und in besonders günstiger Weise geeignet, Magnetfelder wenigstens teilweise abzuschirmen.

Es hat sich dabei im Rahmen der vorliegenden Erfindung als sehr vorteilhaft erwiesen, wenn die Schicht, die die vorstehend genannten Fasern enthält, in Form eines Gewebes oder Geleges oder Gestricks oder Gewirkes oder Vlieses ausgebildet ist.
Ein textiles Flächengebilde gemäß der vorliegenden Erfindung, bei der die Schicht in Form eines Gewebes oder Geleges oder Gestricks oder Gewirkes oder Vlieses ausgebildet ist, ist durch vergleichsweise einfache Herstellungstechniken zugänglich. Dadurch wird das textile Flächengebilde der vorliegenden Erfindung kostengünstig und ist in großer Menge verfügbar.

Bei dem textilen Flächengebilde der vorliegenden Erfindung ist vorgesehen, dass die Schicht, welche Fasern der vorstehend genannten Art enthält, darüber hinaus auch noch das weichmagnetische Material, wie weiter oben beschrieben, enthält.

Hierzu kann beispielsweise ein Gewebe vorliegen, bei dem bei Kette und / oder Schuss Glasfasern und Drähte aus weichmagnetischem Material einander abwechseln. Dadurch wird ein Gewebe verfügbar, welches bedingt durch die Glasfasern eine ausreichende Festigkeit und Flexibilität aufweist, wobei die enthaltenen Drähte aus weichmagnetischem Material die wirksame Abschirmung von Magnetfeldern ermöglichen.

Die Aufgabe der Erfindung, eine Stromleitungsanordnung, welche wenigstens ein Höchstspannungskabel umfasst und bei der das vom Höchstspannungskabel ausgehende Magnetfeld möglichst effektiv abgeschirmt ist, erfährt ihre Lösung in Anspruch 8.

Im Rahmen der vorliegenden Erfindung wurde erkannt, dass eine Stromleitungsanordnung, umfassend wenigstens ein Höchstspannungskabel, dann besonders effektiv ist hinsichtlich der Abschirmung des vom Höchstspannungskabel ausgehenden Magnetfeldes, wenn ein textiles Flächengebilde, wie vorstehend beschrieben, um das Höchstspannungskabel angeordnet ist. Solche Stromleitungsanordnungen sind in bevorzugter Weise unter der Erdoberfläche eingebaut. Durch das Vorsehen des textilen Flächengebildes ist das von dem wenigstens einen Höchstspannungskabel ausgehende Magnetfeld weitgehend abgeschirmt.

In einer sehr günstigen Weiterbildung der vorliegenden Erfindung kann vorgesehen sein, dass der Raum zwischen dem wenigstens einen Höchstspannungskabel und dem textilen Flächengebilde ein Verfüllmaterial, das Beton oder thermisch leitfähiger Beton oder ein thermisch stabilisierter Boden oder eine Mischung der vorgenannten ist, enthält.

Durch diese Maßnahme kann in besonders effektiver Weise Wärmeenergie, die beim Betrieb eines Höchstspannungskabels unweigerlich freigesetzt wird, an das umgebende Erdreich abgeführt werden.

Bei der vorliegenden Erfindung hat es sich als sehr vorteilhaft erwiesen, wenn folgendes Verfahren zum Einbau einer Stromleitungsanordnung unter der Erdoberfläche angewandt wird:

Im ersten Schritt ist ein Graben auszuheben, der etwas tiefer und breiter herzustellen ist als die Anordnung an Höchstspannungskabeln, die in diesen Graben unter der Erdoberfläche zu verlegen sind.

Anschließend ist in den Graben das textile Flächengebilde der vorliegenden Erfindung derart einzulegen, dass es möglichst überall an der Grabenwandung anliegt.
Hierzu eignet sich in sehr vorteilhafter Weise Rollenware, die unkompliziert in einen derartigen Graben einlegbar ist.

Die Breite des textilen Flächengebildes soll dabei so gewählt werden, dass dessen zwei Seitenenden später übereinandergeschlagen werden können und sich dabei berühren.

In den derartig ausgekleideten Graben sind das wenigstens eine Höchstspannungskabel und optional ein Verfüllmaterial, beispielsweise Beton oder thermisch leitfähiger Beton oder ein thermisch stabilisierter Boden oder ein Flüssigboden oder eine Mischung der vorgenannten, einzubringen.

Bei der Einbringung von Flüssigboden ist dafür Sorge zu tragen, dass ein ggf. vorgesehenes Kabelschutzrohr, in welches später das Höchstspannungskabel eingezogen werden kann, nicht durch Auftriebskräfte unerwünscht seine Lage verändert. Hierzu können geeignete Anker eingesetzt werden, die dem Auftrieb entgegenwirken und die Lage des Kabelschutzrohres fixieren.

Nachdem diese Anordnung etwas verfestigt ist, wozu beispielsweise eine Rüttelmaschine einsetzbar ist bzw. im Falle eines eingebrachten Flüssigbodens nach einer gewissen Verfestigungszeit, sind die Endseiten des textilen Flächengebildes derart übereinanderzuschlagen, dass das wenigstens eine Höchstspannungskabel bzw. das ggf. vorgesehene Kabelschutzrohr allseitig von dem textilen Flächengebilde umgeben ist.

Unter "allseitig umgeben" ist im vorliegenden Erfindungszusammenhang zu verstehen, dass das Höchstspannungskabel entlang seiner Längserstreckung um seinen ganzen Umfang oder etwa um seinen ganzen Umfang von dem textilen Flächengebilde umgeben ist.

Anschließend kann durch Verfüllen des restlichen freien Raumes beispielsweise mit dem Aushub des Erdbodens bei der Herstellung des Grabens wieder das Niveau der Erdoberfläche hergestellt werden.

Daran anschließend kann dann das Höchstspannungskabel in das ggf. vorgesehene Kabelschutzrohr eingezogen werden.

Auf diese Weise kann mit vergleichsweise einfachen Tiefbautechniken unter Verwendung des textilen Flächengebildes der vorliegenden Erfindung eine Stromleitungsanordnung schnell und kostengünstig hergestellt werden, die hinsichtlich der Abschirmung des sich beim Betrieb bildenden Magnetfelds optimiert ist.

Die Trasse der Stromleitungsanordnung kann dann in geeigneter Weise markiert werden, beispielsweise durch das Aufstellen von Markierungselementen, hierzu können Pfeiler oder Fahnen genutzt werden.

Die vorliegende Erfindung wird anhand der beigefügten Figuren wie folgt näher erläutert:

Hierzu zeigt:
- Fig. 1: ein textiles Flächengebilde einer ersten Ausführungsart in einer schematischen, perspektivischen Ansicht;
- Fig. 2: ein textiles Flächengebilde einer zweiten Ausführungsart in einer schematischen, perspektivischen Ansicht;
- Fig. 3: eine schematische Querschnittsansicht eines Erdbodens;
- Fig. 4: eine schematische Querschnittsansicht eines Grabens im Erdboden;
- Fig. 5: eine schematische Querschnittsansicht eines Grabens im Erdboden, in den ein textiles Flächengebilde eingelegt ist;
- Fig. 6: eine schematische Querschnittsansicht eines Grabens im Erdboden, in den ein textiles Flächengebilde eingelegt ist und in den Höchstspannungskabel und ein Verfüllmaterial eingebracht ist;
- Fig. 7: eine schematische Querschnittsansicht einer Stromleitungsanordnung in einem Graben im Erdboden;
- Fig. 8: eine schematische Querschnittansicht einer Stromleitungsanordnung in einem Graben im Erdboden mit einer wieder hergestellten Erdoberfläche.

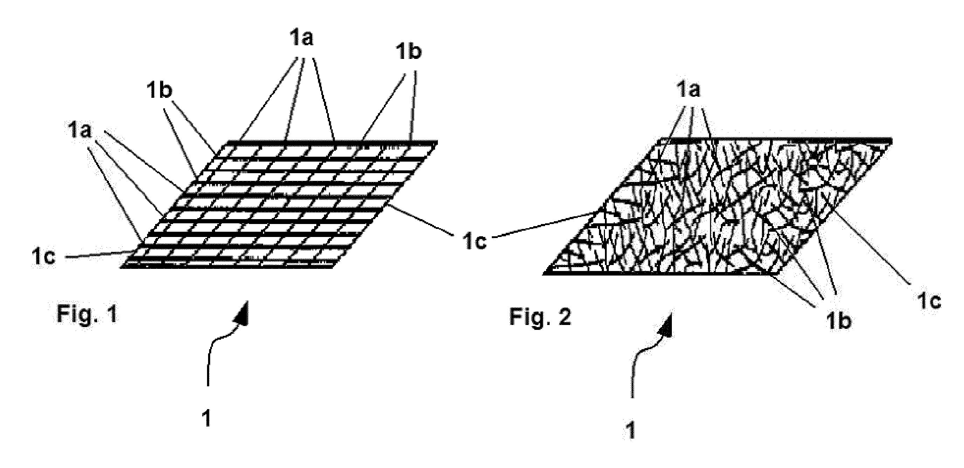

Fig. 1 zeigt in einer schematischen, perspektiven Ansicht ein textiles Flächengebilde 1 in einer ersten Ausführungsart. Das textile Flächengebilde 1 ist als Gewebe ausgebildet, welches aus Kett- und Schussfäden besteht. In Kette und Schuss sind abwechselnd Glasfasern 1 a und Fasern aus weichmagnetischem Material 1 b angeordnet. Die Glasfasern 1 a und die Fasern aus weichmagnetischem Material 1 b überkreuzen sich jeweils nach Art der grundsätzlich bekannten Webtechniken. Hierdurch wird das textile Flächengebilde 1 gebildet. Das textile Flächengebilde 1 weist zwei Seitenenden 1 c auf, die beispielsweise als Webrand des textilen Flächengebildes 1 ausgebildet sind. Bedingt durch den Webvorgang weist das textile Flächengebilde 1 eine maximale Breite auf, kann aber in seiner Länge beliebig lang angefertigt werden. Vorteilhaft ist das textile Flächengebilde 1 auf einer Rolle aufzuwickeln, was hier nicht gezeigt ist.

In Fig. 2 ist ein textiles Flächengebilde 1 einer zweiten Ausführungsart in einer schematischen, perspektiven Ansicht gezeigt. Das textile Flächengebilde 1 der zweiten Ausführungsart ist als Vlies oder Wirrgelege ausgebildet. Hierbei sind Glasfasern 1a und Fasern aus weichmagnetischem Material 1 b unorientiert angeordnet und verdichtet, wobei hierzu ein Prozess wie beim Filzen heranziehbar ist. Das textile Flächengebilde 1 der zweiten Ausführungsart ist durch die hohe innere Reibung der Fasern, die aneinander anliegen, stabilisiert. Auch das textile Flächengebilde 1 der zweiten Ausführungsart weist zwei Seitenenden 1c auf. Ebenso kann das textile Flächengebilde 1 der zweiten Ausführungsart eine bestimmte vorgegebene Breite aufweisen und als Rollenware zur Verfügung gestellt werden.

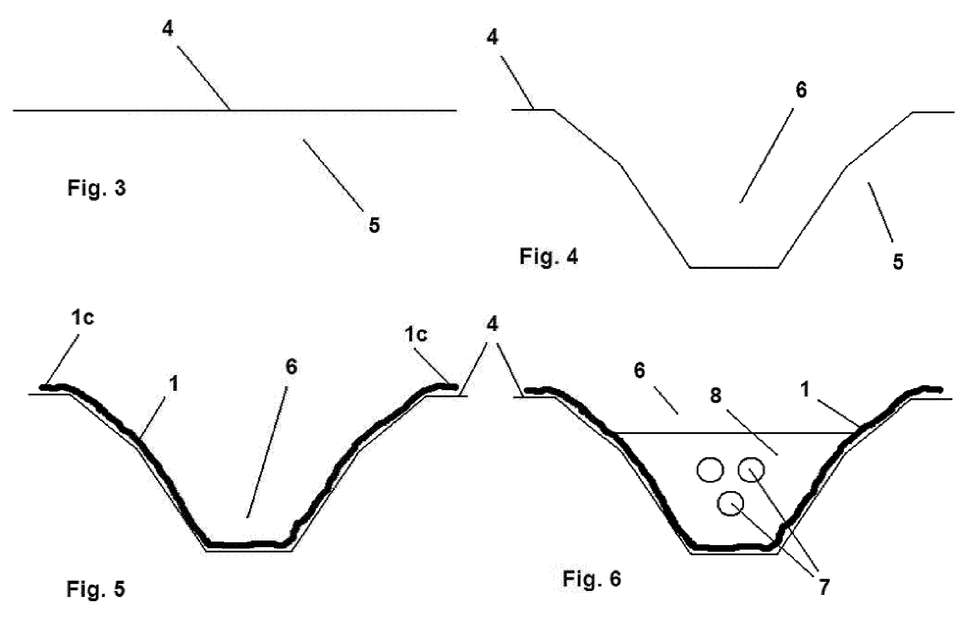

In Fig. 3 ist schematisch in einer Querschnittsansicht der Erdboden 5 und die Erdoberfläche 4 dargestellt. Die Erdoberfläche 4 begrenzt die Ausdehnung des Erdbodens 5 nach oben, also entgegen der Schwerkraft.

In Fig. 4 ist in einer schematischen Querschnittsansicht ein Graben 6 gezeigt, der durch Ausheben von Erdreich 5 im Erdreich 5 nach Durchbrechen der Erdoberfläche 4 hergestellt ist. Der Graben 6 ist gemäß Abb. 4 etwa trapezförmig ausgebildet und kann in einfacher Weise beispielsweise mittels eines Baggers erzeugt werden.
Die Ausdehnung des Grabens hinsichtlich Tiefe, Breite und Länge richtet sich nach den Erfordernissen und technischen Vorgaben, darin Höchstspannungskabel anzuordnen.
In Fig. 5 ist in einer schematischen Querschnittsansicht gezeigt, dass in den Graben 6 im Erdboden 5 ein textiles Flächengebilde 1 eingelegt ist, das möglichst formschlüssig an den Wänden des Grabens 6 anliegt.
Die Größe des textilen Flächengebildes 1 zum Einlegen in den Graben 6 ist dabei so zu wählen, dass die beiden Seitenenden 1c möglichst noch ein Stück aus den Graben 6 herausreichen und auf der Erdoberfläche 4 positionierbar sind. Dies ist bei der Auswahl der Breite des textilen Flächengebildes 1 zu berücksichtigen.
Das Einlegen des textilen Flächengebildes 1 in den Graben 6 kann in sehr vorteilhafter Weise in einem maschinellen Arbeitsgang erfolgen, in dem beispielsweise unmittelbar hinter dem den Graben 6 aushebenden Bagger eine Vorrichtung mit einer Rolle bewegt wird, von der das textile Flächengebilde 1 abrollbar und in den Graben 6 einlegbar ist.
Sehr vorteilhaft sind dazu Rollen mit einer sehr großen Länge an textilem Flächengebilde 1 einzusetzen, da damit dann lange Strecken des Grabens 6 entsprechend mit dem textilen Flächengebilde 1 auslegbar sind.

In Fig. 6 ist in einer schematischen Querschnittsansicht der Graben 6 gezeigt, in den das textile Flächengebilde 1 eingelegt und an die Wand des Grabens 6 angelegt ist.

Im Graben 6 sind weiterhin drei Höchstspannungskabel 7 positioniert, wobei diese gegenseitig etwa gleich beabstandet sind. Die drei Höchstspannungskabel 7 sind dabei in Form etwa eines gleichseitigen Dreiecks angeordnet. Die Höchstspannungskabel 7 sind dabei zu beabstanden, um die Wärmeenergie, die beim Stromfluss durch die Höchstspannungskabel 7 entsteht, gleichmäßig zu verteilen, ohne dass dabei ein "hot spot" mit unerwünscht hohen Temperaturen entsteht, und an den umgebenden Erdboden 5 abzuführen.

Der Freiraum zwischen den Höchstspannungskabeln 7 und dem textilen Flächengebilde 1 ist mit einem Verfüllmaterial 8, beispielsweise einem Beton oder einem thermisch leitfähigen Beton oder einem thermisch stabilisierten Boden aufgefüllt. Die Auffüllung ist dabei soweit erfolgt, dass Verfüllmaterial 8 etwa in gleicher Höhe unter dem zu unterst liegenden Höchstspannungskabel 7 und über dem zu oberst liegenden Höchstspannungskabel 7 zum Liegen kommt. Vorteilhafterweise wird das Verfüllmaterial 8 verdichtet, wozu beispielsweise eine Rüttelmaschine heranziehbar ist. Mithilfe der Rüttelmaschine ist es einfach, das Verfüllmaterial 8 im Graben 6 etwa so zu verdichten, dass eine horizontale Abschlussfläche nach oben hergestellt und ein guter Kontakt zum Höchstspannungskabel 7 ohne Spaltbildung erzielt wird. Alternativ kann das Verfüllmaterial 8 auch als Flüssigboden selbstverdichtend eingebracht werden.

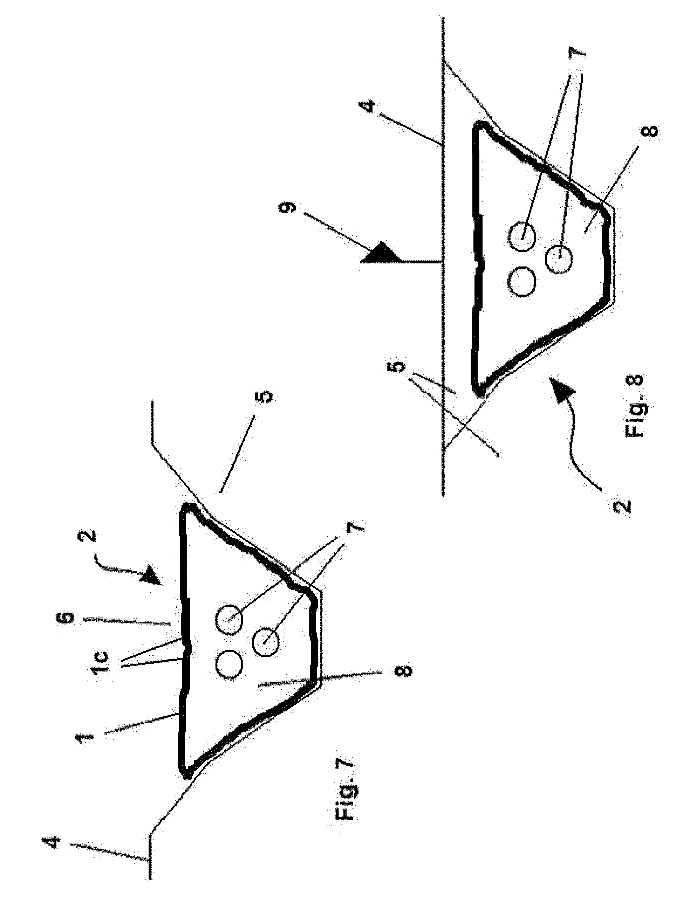

In Fig. 7 ist eine schematische Querschnittsansicht einee Stromleitungsanordnung 2 in einem Graben im Erdboden gezeigt.

Hierzu sind die Seitenenden 1 c des textilen Flächengebildes 1, die bisher an der Wand des Grabens 6 bzw. an der Erdoberfläche 4 anlagen, nun zueinander gelegt und übereinandergeschlagen.
In dieser Anordnung sind die Höchstspannungskabel 7 nun komplett von dem textilen Flächengebilde 1 umgeben, wodurch das sich um die stromdurchflossenen Höchstspannungskabel 7 bildende Magnetfeld zumindest teilweise abgeschirmt wird. Das Übereinanderschlagen der Seitenenden 1 c des textilen Flächengebildes 1 hat dabei so zu erfolgen, dass sich die Seitenenden 1c möglichst direkt berühren, ohne das sich eine Erdschicht oder eine Trennschicht zwischen den beiden Seitenenden 1 c befindet, die deren Kontakt vermindert oder verhindert.

In Fig. 8 ist abschließend ein schematischer Querschnitt einer Stromleitungsanordnung 2 gezeigt.

Diese ist in einem verfüllten Graben 6 angeordnet.
Sie umfasst drei Höchstspannungskabel, um die ein textiles Flächengebilde 1 angeordnet ist.
Der vorher bestehende Graben 6 ist mit Erdboden 5 wieder aufgefüllt und verdichtet, so dass die ursprünglich vorhandene Erdoberfläche 4 in etwa wieder hergestellt ist.
Die Trasse der Stromleitungsanordnung 2 ist durch ein Markierungselement 9, im vorliegenden Fall beispielsweise eine Fahne, gekennzeichnet.

### Bezugszeichenliste

- 1: textiles Flächengebilde
- 1a: Glasfaser
- 1b: Faser aus weichmagnetischem Material
- 1c: Seitenende
- 2: Stromleitungsanordnung
- 4: Erdoberfläche
- 5: Erdboden
- 6: Graben
- 7: Höchstspannungskabel
- 8: Verfüllmaterial
- 9: Markierungselement

## Patentansprüche

1. Textiles Flächengebilde zur Anordnung um wenigstens ein Höchstspannungskabel, um das sich um das stromdurchflossene Höchstspannungskabel bildende Magnetfeld wenigstens teilweise abzuschirmen, mit wenigstens einer Schicht, **dadurch gekennzeichnet, dass** die Schicht ein weichmagnetisches Material enthält.

2. Textiles Flächengebilde nach Anspruch 1, **dadurch gekennzeichnet, dass** das weichmagnetische Material eine magnetische Permeabilitätszahl µr > 500 aufweist.

3. Textiles Flächengebilde nach Anspruch 1 oder 2, **dadurch gekennzeichnet, dass** das weichmagnetische Material Eisen oder eine Eisen-Silizium-Legierung oder eine Eisen-Nickel-Legierung oder ein µ-Metall oder eine Mischung der vorgenannten ist.

4. Textiles Flächengebilde nach einem der vorausgehenden Ansprüche, **dadurch gekennzeichnet, dass** das weichmagnetische Material als Filament oder als Draht oder als Band oder als Folie oder als Partikel ausgebildet ist.

5. Textiles Flächengebilde nach Anspruch 4, **dadurch gekennzeichnet, dass** das Filament oder der Draht als Geflecht oder als Gestrick oder als Zopf oder als eine parallele Draht- oder Filamentschar oder als Wirrgelege angeordnet ist.

6. Textiles Flächengebilde nach einem der vorausgehenden Ansprüche, **dadurch gekennzeichnet, dass** die Schicht Glasfasern oder Kohlenstofffasern oder Gesteinsfasern oder Keramikfasern oder Metallfasern oder Aramidfasern oder Polyesterfasern oder Polyamidfasern und andere Polymerfasern oder eine Kombination der vorstehend genannten Fasern enthält.

7. Textiles Flächengebilde nach einem der vorausgehenden Ansprüche, **dadurch gekennzeichnet, dass** die Schicht in Form eines Gewebes oder Geleges oder Gestricks oder Gewirkes oder Vlieses ausgebildet ist.

8. Stromleitungsanordnung, umfassend wenigstens ein Höchstspannungskabel und ein textiles Flächengebilde nach einem der Ansprüche 1 bis 7, das um das Höchstspannungskabel angeordnet ist.

9. Stromleitungsanordnung nach Anspruch 8, **dadurch gekennzeichnet, dass** diese unter der Erdoberfläche eingebaut ist.

10. Stromleitungsanordnung nach Anspruch 9, **dadurch gekennzeichnet, dass** der Raum zwischen dem wenigstens einem Höchstspannungskabel und dem textilen Flächengebilde ein Verfüllmaterial, das Beton oder thermisch leitfähiger Beton oder ein thermisch stabilisierter Boden oder eine Mischung der vorgenannten ist, enthält.
